# EUROPEAN PATENT APPLICATION

(11) **EP 4 734 722 A1**
(43) Date of publication of application: **29.04.2026**
(21) Application number: 23953679.0
(22) Date of filing: 28.09.2023
(51) Int. Cl.: H10K 59/122

(54) **DISPLAY PANEL AND DISPLAY DEVICE**

(71) Applicant: BOE Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: ZHANG, Wei, Beijing 100176 (CN); FAN, Cong, Beijing 100176 (CN); DONG, Xiangdan, Beijing 100176 (CN)
(74) Representative: Brötz, Helmut
(86) International application number: PCT/CN2023/122643
(87) International publication number: WO 2025/065530

(57) **Abstract**

A display panel and a display device. In the display panel, a first isolation structure (601) is located between adjacent sub-pixels of a plurality of sub-pixels (SP), the first isolation structure (601) being configured to partition at least one of a plurality of film layers of a light-emitting functional layer (FL); the first isolation structure (601) comprises a first isolation portion (PT1) and a second isolation portion (PT2), the first isolation portion (PT1) being located in a first organic insulating layer (Y1), and the second isolation portion (PT2) being located in an inorganic insulating layer (Y0); the inorganic insulating layer has a plurality of through holes (H0) located in a peripheral area (R2); a second organic insulating layer (Y2) is in contact with the first organic insulating layer (Y1) via the plurality of through holes (H0). Therefore, the risk of easy stripping caused by the contact between the inorganic insulating layer and the organic insulating layers is avoided, and the contact reliability is improved, which facilitates the air removal of the organic insulating layer below the inorganic insulating layer, and improves the process reliability.

## Description

### TECHNICAL FIELD

Embodiments of the present disclosure relate to a display panel and a display device.

### BACKGROUND

Organic light-emitting diode (OLED) display products have the advantages of rich colors, being fast in response time and being foldable, etc., and OLED is gradually replacing liquid crystal display (LCD) and serves as the mainstream small and mediumsized display products.

### SUMMARY

Embodiments of the present disclosure provide a display panel and a display device.

Embodiments of the present disclosure provide a display panel, including: a base substrate, including a display region and a peripheral region located on at least one side of the display region; a first organic insulating layer, located in the display region and the peripheral region; a plurality of sub-pixels, including a plurality of light-emitting elements, the plurality of light-emitting elements being located in the display region and located on one side of the first organic insulating layer facing away from the base substrate, the plurality of light-emitting elements including an electrode pattern layer, a common electrode, and a light-emitting functional layer located between the electrode pattern layer and the common electrode, the electrode pattern layer including a plurality of pixel electrodes independent from each other, the light-emitting functional layer including a plurality of film layers, and the electrode pattern layer being closer to the base substrate than the common electrode is; an inorganic insulating layer, located in the display region and the peripheral region, and located on one side of the first organic insulating layer facing away from the base substrate; a second organic insulating layer, located on one side of the inorganic insulating layer facing away from the base substrate; and a first separation structure, located between adjacent sub-pixels of the plurality of sub-pixels, the first separation structure being configured to disconnect at least one film layer of the plurality of film layers of the light-emitting functional layer; the first separation structure includes a first separation portion and a second separation portion, the first separation portion is located in the first organic insulating layer, and the second separation portion is located in the inorganic insulating layer, the inorganic insulating layer has a plurality of through holes located in the peripheral region, and the second organic insulating layer is in contact with the first organic insulating layer through the plurality of through holes.

For example, the plurality of through holes are covered by the second organic insulating layer.

For example, the plurality of through holes are formed in a plurality of rows and a plurality of columns.

For example, the plurality of through holes include at least two through holes which are staggered in a first direction and a second direction, and the first direction and the second direction are perpendicular to each other and are parallel with the base substrate.

For example, the second separation portion protrudes from the first separation portion at an edge to form a first protruding portion, and at least one film layer of the plurality of film layers of the light-emitting functional layer is disconnected at the first protruding portion.

For example, the base substrate further includes a first non-display region, the first non-display region is a non-light-emitting region, a second non-display region is arranged between the first non-display region and the display region, the display panel further includes a second separation structure located in the second non-display region, the second separation structure is configured to disconnect at least one film layer of the plurality of film layers and to disconnect the common electrode, the second separation structure includes a third separation portion and a fourth separation portion, the third separation portion is located in the first organic insulating layer, and the fourth separation portion is located in the inorganic insulating layer.

For example, the first organic insulating layer has a first removed portion at the first separation structure, and the first organic insulating layer has a second removed portion at the second separation structure.

For example, a maximum depth of the first removed portion is less than a maximum depth of the second removed portion.

For example, a maximum size of the first removed portion in a direction perpendicular to the base substrate is less than a maximum size of the second removed portion in the direction perpendicular to the base substrate.

For example, the fourth separation portion protrudes from the third separation portion at an edge to form a second protruding portion, and at least one film layer of the plurality of film layers of the light-emitting functional layer and the common electrode are disconnected at the second protruding portion.

For example, the first separation structure is formed into a semi-T-shaped structure, the second separation structure is formed into a semi-T-shaped structure, and a size of the second separation structure in a direction perpendicular to the base substrate is greater than a size of the first separation structure in the direction perpendicular to the base substrate.

For example, the display panel further includes a third separation structure, the third separation structure is located in the second non-display region, and the third separation structure is closer to the first non-display region than the second separation structure is.

For example, a material of the third separation structure is different from a material of the second separation structure.

For example, a material of the third separation structure is a conductive material.

For example, a distance between the third separation structure and the base substrate is less than a distance between the second separation structure and the base substrate.

For example, the third separation structure is I-shaped, and a material of the third separation structure includes metal.

For example, the display panel further includes a conductive line, the conductive line is located in the second non-display region, and an orthographic projection of the inorganic insulating layer on the base substrate overlaps with an orthographic projection of the conductive line on the base substrate.

For example, the second organic insulating layer is located on one side of the electrode pattern layer facing away from the base substrate, and the second organic insulating layer includes a plurality of openings configured to expose the plurality of pixel electrodes.

For example, the second organic insulating layer is located on one side of the electrode pattern layer close to the base substrate, and the second organic insulating layer has a via hole so that the pixel electrode is connected with a pixel circuit through the via hole.

Embodiments of the present disclosure further provide a display device, including any one of the display panels as described above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitations to the present disclosure.
Fig. 1 is a schematic diagram of a light-emitting element.
Fig. 2 is a cross-sectional view of a display panel.
Fig. 3A and Fig. 3B are cross-sectional views of display panels provided by an embodiment of the present disclosure.
Fig. 4 is a plan view of a display panel provided by an embodiment of the present disclosure.
Fig. 5-Fig. 7 are cross-sectional views of partial structures of a display panel provided by an embodiment of the present disclosure.
Fig. 8-Fig. 10 are cross-sectional views of partial structures of a display panel provided by an embodiment of the present disclosure.
Fig. 11 is a schematic diagram of a display panel provided by an embodiment of the present disclosure.
Fig. 12-Fig. 18 are flowcharts of a manufacturing process of a second separation structure and a third separation structure in a display panel provided by an embodiment of the present disclosure.
Fig. 19-Fig. 21 are flowcharts of a manufacturing process of a first separation structure in a display region of a display panel provided by an embodiment of the present disclosure.
Fig. 22 is a schematic diagram of protecting, when forming a second separation structure, a display region of a display panel provided by an embodiment of the present disclosure.
Fig. 23 is a cross-sectional view of a display panel provided by an embodiment of the present disclosure.
Fig. 24 is a plan view of a display panel provided by an embodiment of the present disclosure.

### DETAILED DESCRIPTION

In order to make objects, technical details and advantages of the embodiments of the present disclosure more clear, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment (s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly.

With the continuous development of display technology, people's pursuit of display quality is increasing. In order to further reduce the power consumption, prolong the service life and achieve high brightness, one light-emitting layer in the light-emitting element of the OLED display panel can be replaced with two light-emitting layers, and a charge generation layer (CGL) can be added between the two light-emitting layers. An N-doped charge generation layer and a P-doped charge generation layer (N/P-CGL) are used as a heterojunction to connect two light-emitting component structures in series, thus forming a dual-layered stack design and forming a tandem structure. The display panel with the tandem structure realizes the series connection of two light-emitting components, and under the same luminous intensity, the light-emitting current of the light-emitting element is greatly reduced, and the service life of the light-emitting element is prolonged, which is beneficial to the development and mass production of new technologies with long service life, such as vehicle-mounted devices. The display device with the tandem structure has the advantages of long service life, low power consumption and high brightness, etc.

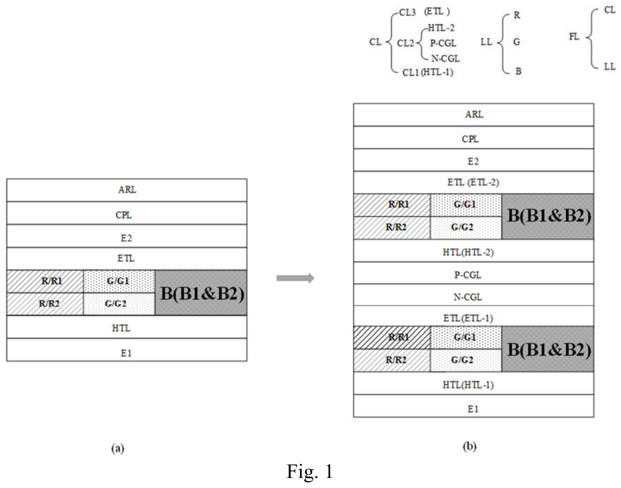

Fig. 1 is a schematic diagram of a light-emitting element. Fig. 1(a) is a schematic diagram of a conventional light-emitting element. Fig. 1(b) is a schematic diagram of a light-emitting element with the tandem structure. As shown in Fig. 1(b), the charge generation layers (CGL) between different light-emitting elements with the tandem structure are connected.

Fig. 1 shows a pixel electrode E1, a common electrode E2, a hole transport layer HTL, an electron transport layer ETL, an optical coupling layer CPL, an anti-reflection layer ARL, a P-type doped charge generation layer P-CGL, an N-type doped charge generation layer N-CGL, a light-emitting layer R, a light-emitting layer G and a light-emitting layer B. As shown in Fig. 1(b), the hole transport layer HTL includes a hole transport layer HTL-1 and a hole transport layer HTL-2. As shown in Fig. 1(b), the electron transport layer ETL includes an electron transport layer ETL-1 and an electron transport layer ETL-2.

For example, as shown in Fig. 1, the light-emitting layer R includes two sub-layers containing a luminescent material r1 and a luminescent material r2 respectively, the light-emitting layer G includes two sub-layers containing a luminescent material g1 and a luminescent material g2 respectively, and the light-emitting layer B includes a luminescent material b1 and a luminescent material b2. For example, the luminescent material r1 and the luminescent material r2 are two different materials that emit red light, the luminescent material g1 and the luminescent material g2 are two different materials that emit green light, and the luminescent material b1 and the luminescent material b2 are two different materials that emit blue light. In other embodiments, the light-emitting layer B can include two sub-layers containing the luminescent material b1 and the luminescent material b2 respectively.

Fig. 1 shows a light-emitting functional layer FL located between the pixel electrode E1 and the common electrode E2, and the light-emitting functional layer FL includes a common layer CL and a local layer LL. The local layer LL includes the light-emitting layer R, the light-emitting layer G, and the light-emitting layer B. The common layer CL includes a first common layer CL1, a second common layer CL2, and a third common layer CL3. As shown in Fig. 1, the first common layer CL1 includes the hole transport layer HTL-1; the second common layer CL2 includes the electron transport layer ETL-1, the charge generation layer N-CGL, the charge generation layer P-CGL, and the hole transport layer HTL-2; and the third common layer CL3 includes the electron transport layer ETL-2.

For example, the common layer CL can be manufactured by using an open mask, and the local layer LL can be manufactured by using a fine metal mask, but it is not limited thereto.

For example, the common layer CL includes at least a charge generation layer, but is not limited thereto.

It should be noted that the light-emitting element with the tandem structure is not limited to that shown in Fig. 1, and can be arranged as needed.

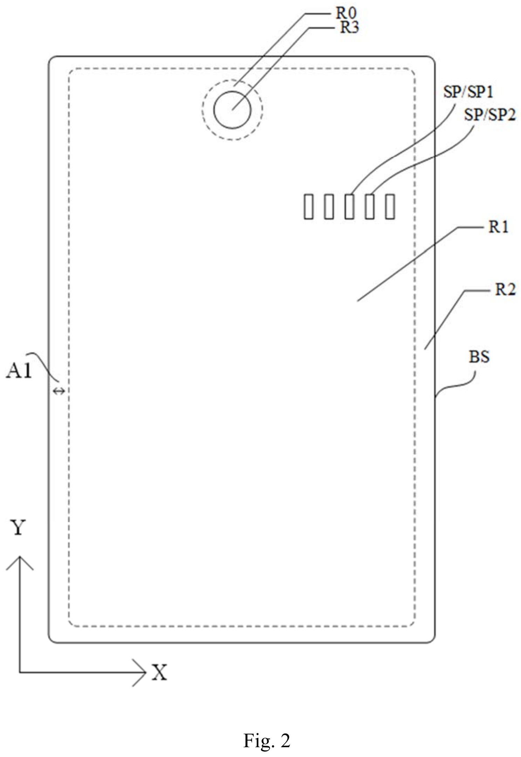

Fig. 2 is a cross-sectional view of a display panel. As shown in Fig. 2, the display panel includes a plurality of sub-pixels SP. Fig. 2 shows a sub-pixel SP1 and a sub-pixel SP2.

For the sake of clarity, Fig. 2 does not show all sub-pixels SP, but only a few sub-pixels SP.

The inventor(s) has/have noticed that in terms of high-resolution products, the common layer CL, such as the charge generation layer, is shared by a plurality of sub-pixels; because the charge generation layer is doped and conductive, and the charge generation layers in the light-emitting functional layers of adjacent sub-pixels are connected, the conductive layer, such as the charge generation layer, in the common layer CL, is likely to cause crosstalk between adjacent sub-pixels, affecting the image quality of the product, thus seriously affecting the display quality.

For example, the crosstalk between adjacent sub-pixels refers to the case in which a sub-pixel that should not emit light emits light. As shown in Fig. 2, the desired case is that the sub-pixel SP1 emits light while the sub-pixel SP2 does not emit light, however, the sub-pixel SP2 also emits light due to the conductivity of the charge generation layer, thus resulting in lateral leakage and crosstalk.

In order to avoid lateral leakage, structures, such as separation pillars, etc., can be set, so as to alleviate or avoid lateral leakage and improve image quality, especially for improving low gray-scale image quality.

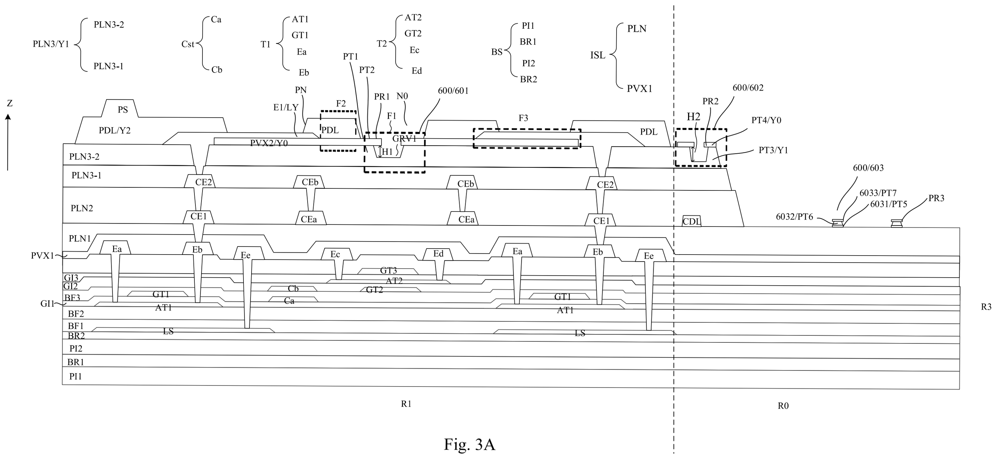

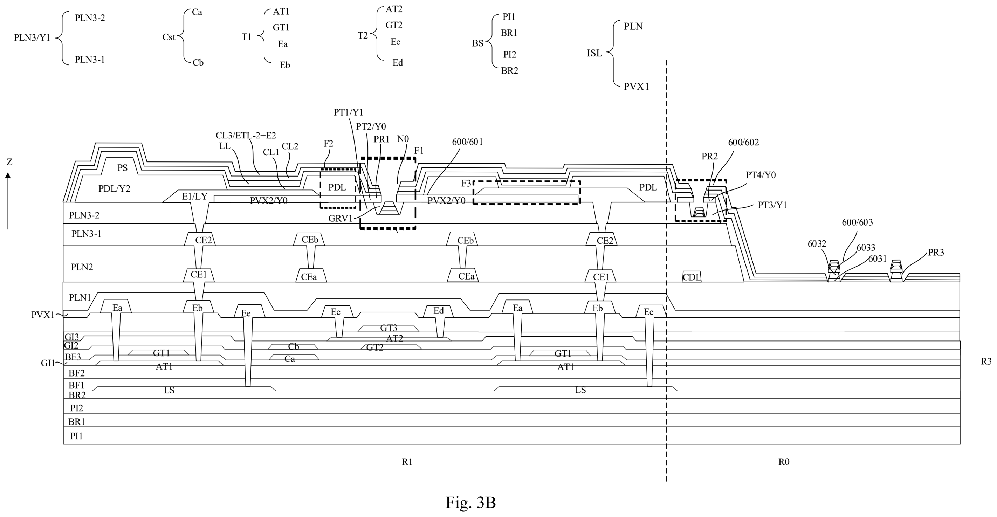

Fig. 3A and Fig. 3B are cross-sectional views of a display panel provided by an embodiment of the present disclosure. As shown in Fig. 2- Fig. 3B, the display panel includes a base substrate BS, and the base substrate BS includes a display region R1 and a peripheral region R2 located on at least one side of the display region R1. For example, the peripheral region R2 surrounds the display region R1. The peripheral region R2 is a non-display region, and the peripheral region R2 can be a wiring region. The display region R1 is used for displaying an image. As shown in Fig. 2- Fig. 3B, the base substrate BS further includes a first non-display region R3, the first non-display region R3 is a non-light-emitting region (non-display region), and a second non-display region R0 is arranged between the first non-display region R3 and the display region R1. For example, the second non-display region R0 is a wiring region, which is a non-light-emitting region (non-display region).

As shown in Fig. 2, the first non-display region R3 is circular. It should be noted that the embodiment of the present disclosure takes the shape of the first non-display region R3 as a circular shape as an example, but the first non-display region R3 can also adopt any other suitable shapes, not limited to the circular shape. Moreover, the setting position of the first non-display region R3 is not limited to that shown in the figure, and can be arranged as needed. For example, conductive lines, such as some gate lines and some data lines, are arranged to wind around the first non-display region R3 to form the second non-display region R0. The second non-display region R0 may be a wiring region.

For example, in the case where the hole-in-display solution is adopted, at least part of the structures in the first non-display region R3 are removed, that is, the hole-in-display solution needs to sacrifice part of the display region to form the first non-display region. For example, all of the structures in the first non-display region R3 of the display panel are removed. For example, after an encapsulation layer is formed, drilling is performed to remove the part of the display panel located in the first non-display region R3. Sensors can be partially arranged in the first non-display region R3 or completely arranged in the first non-display region R3. For example, the sensors include a camera, but not limited thereto.

In the embodiment of the present disclosure, the first non-display region R3 has neither a pixel circuit nor a light-emitting element. The embodiment of the present disclosure is illustrated by taking that all of the structures in the first non-display region R3 are removed to form a through hole as an example. However, in some other embodiments, part of the structures in the first non-display region R3 are removed to form a groove. That is, at least part of the structures located in the first non-display region R3 are removed to form a receiving space for receiving components such as sensors, etc.

On the one hand, in order to prevent water and oxygen from invading the light-emitting element, a separation structure can be arranged in the second non-display region R0 to disconnect the light-emitting functional layer of the light-emitting element, thus preventing water and oxygen from entering the display region R1 along the light-emitting functional layer around the first non-display region R3.

On the other hand, in order to reduce or avoid the crosstalk problem caused by a sub-functional layer with strong conductivity in the light-emitting functional layer, a separation structure can be arranged in the display region.

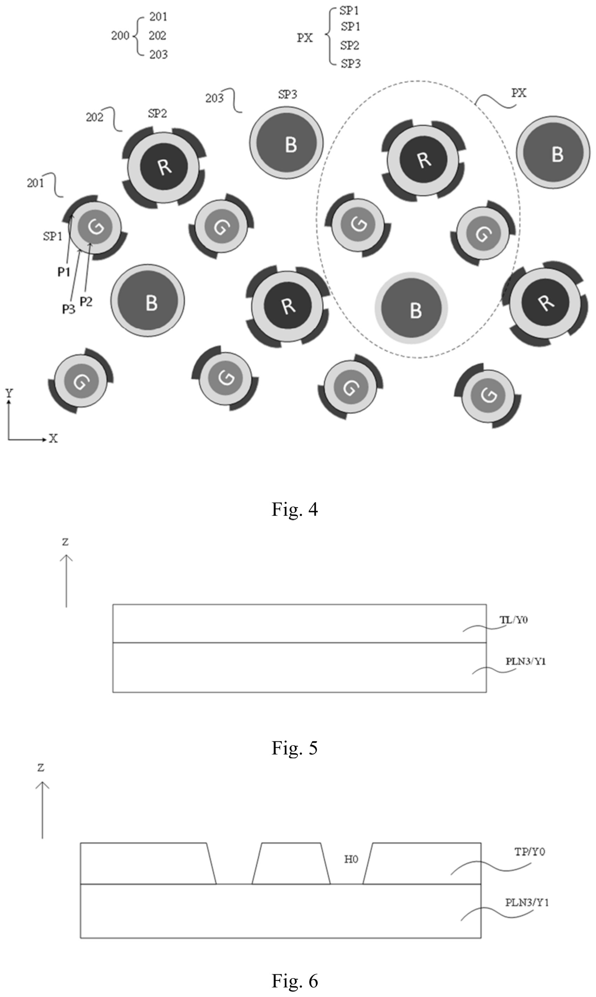

Fig. 3A and Fig. 3B are cross-sectional views of a display panel provided by an embodiment of the present disclosure. Fig. 4 is a plan view of a display panel provided by an embodiment of the present disclosure. Fig. 3A omits the light-emitting functional layer FL and the common electrode E2.

As shown in Fig. 3A and Fig. 3B, a first separation structure 601 is provided (at the dashed frame F1). A passivation layer PVX2 is arranged on the planarization layer PLN3, and the planarization layer PLN3 is provided with a first removed portion GRV1 (groove or through hole) at the position where the passivation layer PVX2 is arranged, and therefore, a first separation structure 601, which can be used to disconnect the common layer in the light-emitting functional layer, is formed, so as to alleviate or avoid lateral leakage and improve image quality.

The remaining structures in Fig. 3A and Fig. 3B will be described later.

Fig. 4 shows sub-pixels SP1, sub-pixels SP2, and sub-pixels SP3. For example, two sub-pixels SP1, one sub-pixel SP2, and one sub-pixel SP3 form a repeating unit PX. As shown in Fig. 3B and Fig. 4, the sub-pixel SP includes a light-emitting element 200. As shown in Fig. 4, the sub-pixel SP1 includes a light-emitting element 201, the sub-pixel SP2 includes a light-emitting element 202, and the sub-pixel SP3 includes a light-emitting element 203. Fig. 4 shows a sub-pixel by using a light-emitting region of a light-emitting element of the sub-pixel. As shown in Fig. 4, the position P2 is the outer edge of the light-emitting region of the light-emitting element of the sub-pixel. The position P3 is the outer edge of the passivation layer PVX2 for forming the first separation structure 601. The position P1 is a position where the first separation structure 601 is located. The outermost arc-shaped portion (arc-shaped portion close to the position P1) of the light-emitting element shown in Fig. 4 is an opening N0 in a pixel defining layer PDL that exposes the first separation structure 601 (as shown in Fig. 3A and Fig. 3B). The opening N0 is provided to facilitate that the first separation structure 601 plays a role of disconnecting the light-emitting functional layer.

For example, the light-emitting element 200 includes an organic light-emitting diode, but it is not limited thereto.

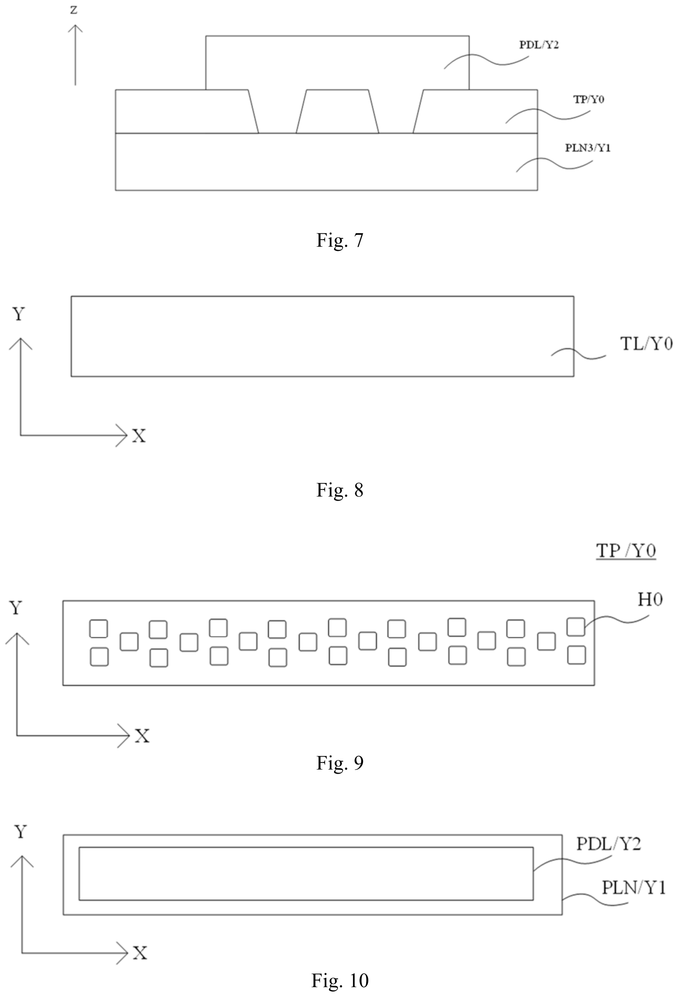

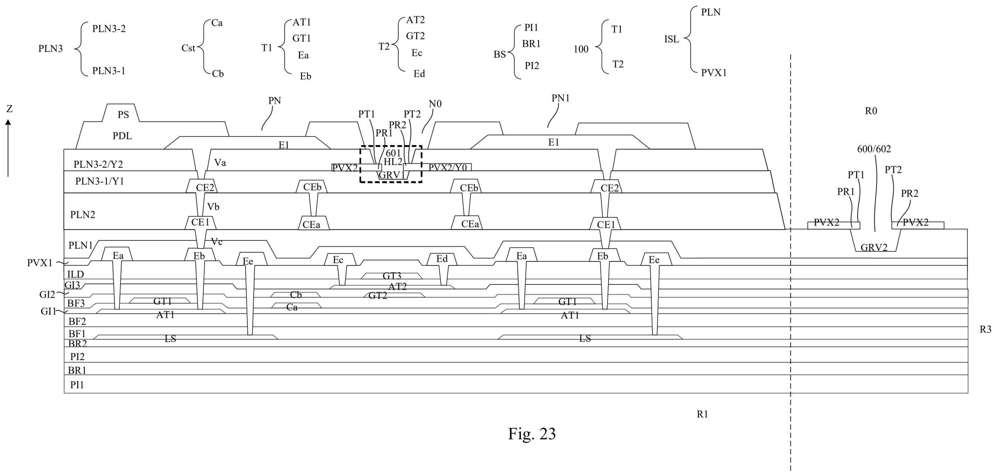

Fig. 5-Fig. 7 are cross-sectional views of partial structures of a display panel provided by an embodiment of the present disclosure. Fig. 8-Fig. 10 are cross-sectional views of partial structures of a display panel provided by an embodiment of the present disclosure. Fig. 3A and Fig. 3B show the structures of a display region and a second non-display region R0. Fig. 5-Fig. 10 show partial structures in the peripheral region R2. Fig. 5-Fig. 10 can be schematic diagrams of the structures at the position A in Fig. 2. The inorganic insulating layer Y0 in the display panel shown in Fig. 7 and Fig. 10 can be the passivation layer PVX2 shown in Fig. 3A, Fig. 3b or Fig. 23, but it is not limited thereto.

As shown in Fig. 3A-Fig. 10, the embodiment of the present disclosure provides a display panel, which includes a base substrate BS, a first organic insulating layer Y1, a plurality of sub-pixels SP, an inorganic insulating layer Y0, a second organic insulating layer Y2, and a first separation structure 601 (separation structure 600). The base substrate BS includes a display region R1 and a peripheral region R2 located on at least one side of the display region R1; the first organic insulating layer Y1 is located in the display region R1 and the peripheral region R2; the plurality of sub-pixels SP include a plurality of light-emitting elements 200, the plurality of light-emitting elements 200 are located in the display region R1 and located on one side of the first organic insulating layer Y1 facing away from the base substrate BS, the plurality of light-emitting elements 200 include an electrode pattern layer LY, a common electrode E2, and a light-emitting functional layer FL located between the electrode pattern layer LY and the common electrode E2, the electrode pattern layer LY includes a plurality of pixel electrodes E1 independent from each other, the light-emitting functional layer FL includes a plurality of film layers, and the electrode pattern layer LY is closer to the base substrate BS than the common electrode E2 is; the inorganic insulating layer Y0 is located in the display region R1 and the peripheral region R2, and located on one side of the first organic insulating layer Y1 facing away from the base substrate BS; and the second organic insulating layer Y2 is located on one side of the inorganic insulating layer Y0 facing away from the base substrate BS. The first separation structure 601 is located between adjacent sub-pixels SP of the plurality of sub-pixels SP, and the first separation structure 601 is configured to disconnect at least one film layer of the plurality of film layers of the light-emitting functional layer FL (at least one film layer of the common layer CL); the first separation structure 601 includes a first separation portion PT1 and a second separation portion PT2, the first separation portion PT1 is located in the first organic insulating layer Y1, the second separation portion PT2 is located in the inorganic insulating layer Y0, the inorganic insulating layer Y0 has a plurality of through holes H0 located in the peripheral region R2, and the second organic insulating layer Y2 is in contact with the first organic insulating layer Y1 through the plurality of through holes H0.

In the display panel provided by the embodiment of the present disclosure, the inorganic insulating layer Y0 has a plurality of through holes H0 located in the peripheral region R2, so that the second organic insulating layer Y2 is in contact with the first organic insulating layer Y1 through the plurality of through holes H0 (as shown in Fig. 7), thereby increasing the bonding force, avoiding the risk of easy peeling caused by the contact between the inorganic insulating layer and the organic insulating layer, improving the contact reliability, facilitating the outgassing of the organic insulating layer below the inorganic insulating layer and improving the process reliability.

As shown in Fig. 5 and Fig. 8, an inorganic insulating film TL is formed on the planarization layer PLN3.

As shown in Fig. 6 and Fig. 9, a plurality of through holes H0 are formed in the inorganic insulating film TL, so as to form an inorganic insulating portion TP (a portion of the inorganic insulating layer Y0 located in the peripheral region R2). For example, in the peripheral region R2, the portion, with a size greater than 10µm×10µm, of the inorganic insulating layer Y0 located in the peripheral region R2 can be provided with a through hole H0.

As shown in Fig. 7 and Fig. 10, the pixel defining layer PDL is in contact with the planarization layer PLN through the plurality of through holes H0.

The planarization layer PLN3 in Fig. 3A, Fig. 3B and Fig. 5- Fig. 10 is the first organic insulating layer Y1, and the pixel defining layer PDL is the second organic insulating layer Y2. The embodiment of the present disclosure includes but is not limited to this case.

For example, as shown in Fig. 7 and Fig. 10, the second organic insulating layer Y2 (pixel defining layer PDL) covers the plurality of through holes H0, so as to improve the bonding force between the second organic insulating layer Y2 and the first organic insulating layer Y1 and avoid peeling.

For example, as shown in Fig. 9, the plurality of through holes H0 are formed in a plurality of rows and a plurality of columns, so as to facilitate the improvement of the bonding force between the second organic insulating layer Y2 and the first organic insulating layer Y1.

For example, as shown in Fig. 9, the plurality of through holes H0 includes at least two through holes H0 which are staggered in a first direction X and a second direction Y, and the first direction X and the second direction Y are perpendicular to each other and are parallel with the base substrate BS. The stagger arrangement of the through holes H0 is helpful to improve the bonding force between the second organic insulating layer Y2 and the first organic insulating lay Y1.

Of course, in other embodiments, the plurality of through holes H0 can also be arranged in other ways, and for example, the plurality of through holes H0 can be arranged in an array.

For example, as shown in Fig. 3A and Fig. 3B, the second separation portion PT2 protrudes from the first separation portion PT1 at the edge to form a first protruding portion PR1, and at least one film layer of the plurality of film layers of the light-emitting functional layer FL (at least one film layer of the common layer CL) is disconnected at the first protruding portion PR1.

For example, as shown in Fig. 3A and Fig. 3B, the second organic insulating layer Y2 is located on one side of the electrode pattern layer LY facing away from the base substrate BS, and the second organic insulating layer Y2 includes a plurality of openings PN configured to expose the plurality of pixel electrodes E1. That is, the second organic insulating layer Y2 is the pixel defining layer PDL. The pixel defining layer PDL has a plurality of openings PN exposing the plurality of pixel electrodes E1. The plurality of openings PN correspond to the light-emitting regions of the light-emitting elements or sub-pixels.

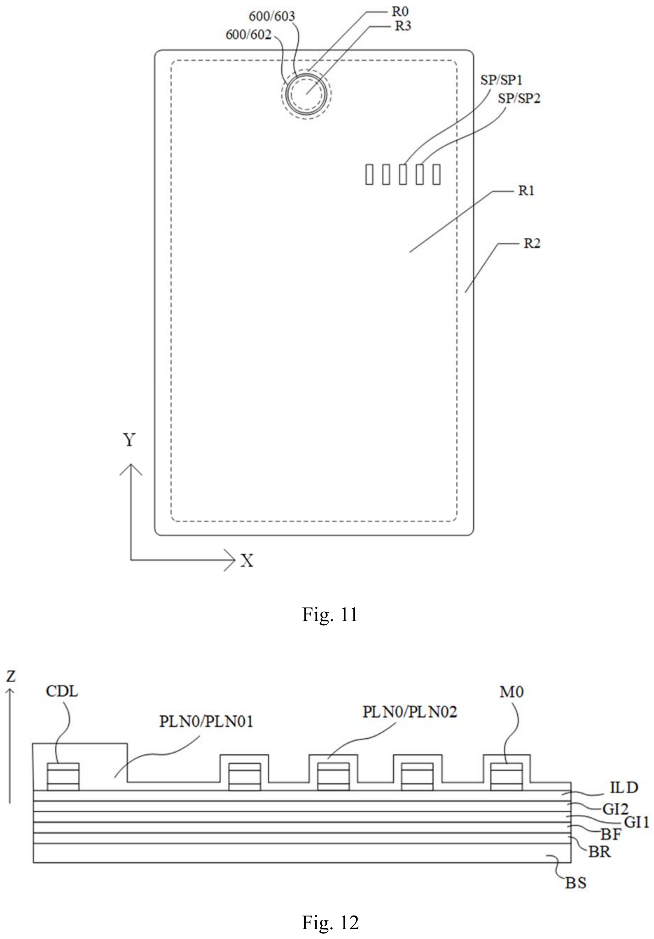

Fig. 11 is a schematic diagram of a display panel provided by an embodiment of the present disclosure. Fig. 12- Fig. 18 are flowcharts of a manufacturing process of a second separation structure and a third separation structure in a display panel provided by an embodiment of the present disclosure. Fig. 12- Fig. 18 show a second separation structure 602 and a third separation structure 603 located in the second non-display region R0.

Fig. 11 does not show the first separation structure 601 located between adjacent sub-pixels SP. The first separation structure 601 can be referred to that shown in Fig. 3A and Fig. 3B. Fig. 11 merely illustratively shows one second separation structure 602 and one third separation structure 603. However, the number of the second separation structures 602 and the number of the third separation structures 603 are not limited to those shown in the figure. In the embodiment of the present disclosure, the third separation structure 603 is closer to the first non-display region R3 than the second separation structure 602 is. For example, in the case where one or more second separation structures 602 and one or more third separation structures 603 are provided, the one or more third separation structures 603 are closer to the first non-display region R3 than the one or more second separation structures 602 are. As shown in Fig. 12- Fig. 18, a plurality of third separation structures 603 are closer to the first non-display region R3 than the second separation structures 602 are.

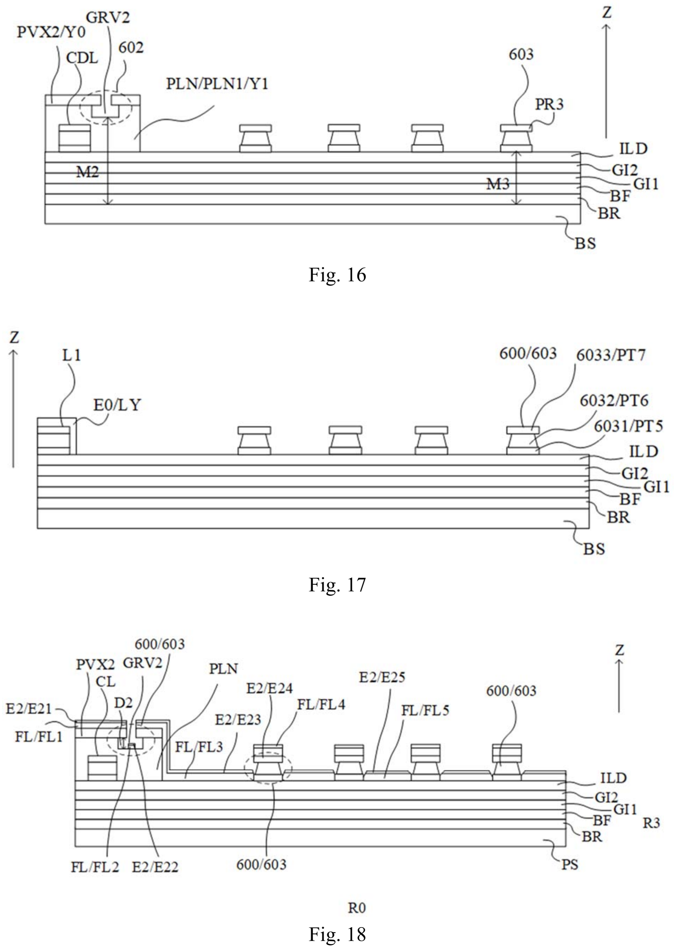

As shown in Fig. 12, a barrier layer BR is formed on the base substrate BS, a buffer layer BF is formed on the barrier layer BR, a gate insulating layer GI1 is formed on the buffer layer BF, a gate insulating layer GI2 is formed on the gate insulating layer GI1, an interlayer insulating layer ILD is formed on the gate insulating layer GI2, a separation structure intermediate pattern M0 and a conductive line CDL are formed on the interlayer insulating layer ILD, and a planarization film PLN0 is formed on the separation structure intermediate pattern M0 and the conductive line CDL; the planarization film PLN0 includes a planarization film PLN01 and a planarization film PLN02, and the thickness of the planarization film PLN01 is different from the thickness of the planarization film PLN02, the thickness of the planarization film PLN01 is greater than the thickness of the planarization film PLN02, and for example, the thickness of the planarization film PLN02 can be half of the thickness of the planarization film PLN01, but it is not limited thereto. As shown in Fig. 12, the planarization film PLN01 covers the conductive line CDL, and the planarization film PLN02 covers the separation structure intermediate pattern M0. As shown in Fig. 16 and Fig. 18, the planarization layer PLN can play a role in protecting the conductive line CDL.

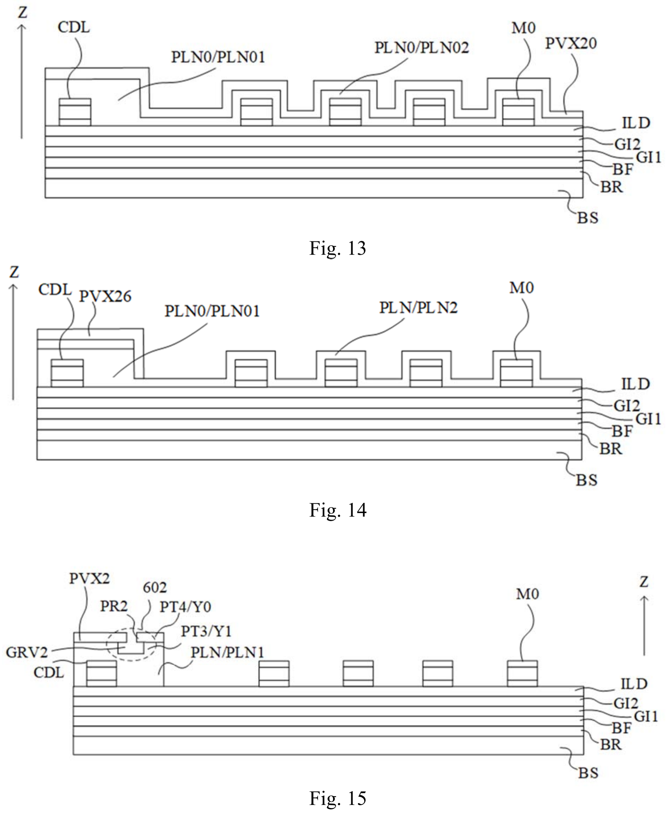

As shown in Fig. 13, a passivation film PVX20 is formed on the planarization film PLN0. The passivation film PVX20 is an inorganic film.

As shown in Fig. 14, the passivation film PVX20 and the planarization film PLN0 are dry etched in turn.

As shown in Fig. 15, portions of the passivation film PVX20 and the planarization film PLN0 located in the second non-display region R0 are etched by using a dry etching process, so as to form a second separation structure 602, and to form a passivation layer PVX2 (inorganic insulating layer Y0) and a planarization layer PLN (first organic insulating layer Y1). The second removed portion GRV2 can be designed to be deepened, so that the depth of the second removed portion GRV2 can be adjusted deeper. For example, the second removed portion GRV2 can be formed by increasing the etching time or adjusting the concentration of the etching gas.

As shown in Fig. 16 and Fig. 17, in the same patterning process, a pixel electrode E1 and a third separation structure 603 are formed. That is, the separation structure intermediate pattern M0 and the electrode film are etched by using the same patterning process, so as to form the pixel electrode E1 and the third separation structure 603, simultaneously. Fig. 17 shows a connection electrode E0 located in the same layer as the pixel electrode E1. The connection electrode E0 is in contact with the conductive line L1, so as to form a conductive connection structure.

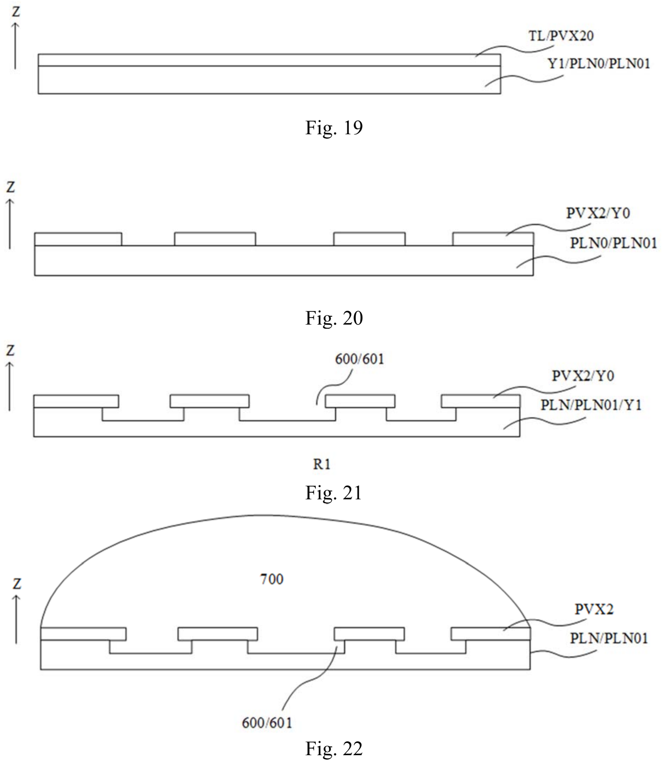

Fig. 19-Fig. 21 are flowcharts of a manufacturing process of a first separation structure in a display region of a display panel provided by an embodiment of the present disclosure. Fig. 22 is a schematic diagram of protecting, when forming a second separation structure, a display region of a display panel provided by an embodiment of the present disclosure.

As shown in Fig. 19, a passivation film PVX20 (inorganic insulating film TL) is formed on the planarization film PLN0 (planarization film PLN01).

As shown in Fig. 20 and Fig. 21, the passivation film PVX20 and the planarization film PLN0 (planarization film PLN01) are sequentially etched to form a passivation layer PVX2 (inorganic insulating layer Y0) and a planarization layer PLN (first organic insulating layer Y1).

As shown in Fig. 22, in the etching process of forming the second separation structure 602, a protective layer 700 is used to protect the structures of the display region. That is, the protective layer 700 is used to cover the structures located in the display region. For example, the protective layer 700 includes photoresist, but is not limited thereto. In the process of forming the second removed portion GRV2 of the second separation structure 602, the process of the first separation structure 601 in the display region is not affected, and the second removed portion GRV2 can be set deeper to better disconnect the light-emitting functional layer and the common electrode in the second non-display region, so as to better eliminate the electrochemical reaction at the third separation structure 603 in the second non-display region and avoid the generation of dark spots.

Hereinafter, with reference to Fig. 3A, Fig. 3B, Fig. 5- Fig. 10 and Fig. 12- Fig.22, the manufacturing processes of the structures in the display region, the peripheral region, and the second non-display region of the display panel are described.

Step 1): A planarization film PLN0 is formed on the base substrate with a pixel circuit 100 and a separation structure intermediate pattern M0 formed thereon.

Step 2): the portion of the planarization film PLN0 located in the second non-display region R0 is thinned, while the portion of the planarization film located in the display region R1 and the peripheral region R2 is not thinned and has a conventional thickness.

For example, a halftone mask can be used for the thinning operation. For example, the conventional thickness is 100 Å -30000 Å, but it is not limited thereto.

Step 3): An inorganic insulating film (passivation film PVX20) is formed on the planarization film PLN0. The inorganic insulating film (passivation film PVX20) is formed in the display region R1, the peripheral region R2 and the second non-display region R0.

Step 4): The inorganic insulating film (passivation film PVX20) is etched by using a dry etching process, so as to form a through hole H0 in the peripheral region, and form a second separation portion PT2 and a first removed portion GRV1 in the display region (a first separation portion PT1 is formed simultaneously).

Step 5): By using a dry etching process, the portion of the planarization film PLN0 located in the second non-display region R0 is further removed, and the first removed portion GRV1 is formed in the display region R1 and a second removed portion GRV2 is formed in the second non-display region R0.

Step 6): The structures located in the display region are protected by using a protective layer 700, and etching is performed by using a dry etching process to form the second removed portion GRV2 and a fourth separation portion PT4 of the second separation structure 602 located in the second non-display region (a third separation portion PT3 is formed simultaneously), and the protective layer 700 is removed. The structures of the display region are covered by the protective layer 700, such as photoresist, so as not to be subjected to the etching process. The second removed portion GRV2 can be designed to be deepened.

Step 7): an electrode film is formed.

Step 8): The electrode film and the separation structure intermediate pattern M0 are etched by using the same etching process, so as to form a plurality of pixel electrodes E1 in the display region and a third separation structure 603 in the second non-display region R0. The second sub-layer 602 in the third separation structure 603 is laterally etched, so as to form an undercut structure.

In the display panel provided by the embodiment of the present disclosure, the first separation structure 601 is formed in the display region, and the second separation structure 602 and the third separation structure 603 are formed in the second non-display region R0, which is helpful to disconnect the light-emitting functional layer FL and to disconnect the common electrode E2 in the second non-display region.

As shown in Fig. 2, Fig. 3A, Fig. 3B and Fig. 11- Fig. 18, the base substrate BS further includes a first non-display region R3, the first non-display region R3 is a non-light-emitting region, and a second non-display region R0 is arranged between the first non-display region R3 and the display region R1.

As shown in Fig. 3A, Fig. 3B, Fig. 12 and Fig. 15, the display panel further includes a second separation structure 602 (separation structure 600) located in the second non-display region R0, and the second separation structure 602 is configured to disconnect at least one film layer of the plurality of film layers (at least one film layer of the common layer CL) and to disconnect the common electrode E2, the second separation structure 602 includes a third separation portion PT3 and a fourth separation portion PT4, the third separation portion PT3 is located in the first organic insulating layer Y1, and the fourth separation portion PT4 is located in the inorganic insulating layer Y0.

In the display panel provided by the embodiment of the present disclosure, the film layer structures of the second separation structure 602 and the first separation structure 601 are the same, which is convenient for manufacturing. For example, the corresponding film layers of the second separation structure 602 and the first separation structure 601 can be manufactured by using the same thin film forming process, and of course, they can also be manufactured by using different patterning processes.

For example, as shown in Fig. 3A and Fig. 15-Fig. 17 , and Fig. 18, the fourth separation portion PT4 protrudes from the third separation portion PT3 at the edge to form a second protruding portion PR2, and at least one film layer of the plurality of film layers of the light-emitting functional layer FL (at least one film layer of the common layer CL) and the common electrode E2 are disconnected at the second protruding portion PR2.

For example, as shown in Fig. 3A, the first organic insulating layer Y1 has a first removed portion GRV1 at the first separation structure 601; and as shown in Fig. 3A and Fig. 15-Fig. 17 , and Fig. 18, the first organic insulating layer Y1 has a second removed portion GRV2 at the second separation structure 602. The first removed portion GRV1 is provided to facilitate the formation of the first protruding portion PR1, and the second removed portion GRV2 is provided to facilitate the formation of the second protruding portion PR2.

For example, as shown in Fig. 3A, in order to facilitate disconnecting the common electrode E2 in the second non-display region R0, to prevent the signal on the common electrode E2 from being transmitted to the second non-display region R0 to cause electrochemical reaction, and to avoid the occurrence of dark spot defects, the maximum depth H1 of the first removed portion GRV1 is less than the maximum depth H2 of the second removed portion GRV2. That is, by deepening the second removed portion GRV2 separately, the common electrode E2 is better disconnected in the second non-display region R0. In the case where the groove depths of the separation structures are different, the groove depth of the second separation structure 602 can be deepened separately.

In the embodiment of the present disclosure, the depth is the height difference of a recessed region (the first removed portion GRV1 or the second removed portion GRV2) relative to a surrounding plane region. Because each region may have a certain height difference itself due to the different film layers below, the recessed region is determined by comparing with the surrounding regions close to the recessed region.

For example, the maximum depth H1 of the first removed portion GRV1 is less than or equal to the thickness of the first organic insulating layer Y1. For example, the maximum depth H1 of the first removed portion GRV1 can be in the range of 50 Å to 0.2 µm, but it is not limited thereto. The maximum depth H1 of the first removed portion GRV1 may correspond to the maximum size of the first separation portion PT1 in the third direction Z. For example, in some embodiments, the maximum depth H1 of the first removed portion GRV1 is less than 0.15 µm. For example, in some embodiments, the maximum depth H1 of the first removed portion GRV1 is less than 0.1 µm. For example, in some embodiments, the maximum depth H1 of the first removed portion GRV1 is less than or equal to 100 Å.

For example, the maximum depth H1 of the second removed portion GRV2 is less than or equal to the thickness of the first organic insulating layer Y1. For example, the maximum depth H2 of the second removed portion GRV2 is less than or equal to 30000 Å. For example, the maximum depth H2 of the second removed portion GRV2 can be in the range of 0.2-0.5 µm, but it is not limited thereto. Further, for example, the maximum depth H2 can be in the range of 0.2-0.3 µm. The maximum depth H2 of the second removed portion GRV2 may correspond to the maximum size of the third separation portion PT3 in the third direction Z.

For example, in the embodiments of the present disclosure, the first removed portion GRV1 can be a groove or a through hole.

For example, in the embodiments of the present disclosure, the second removed portion GRV2 can be a groove or a through hole.

For example, as shown in Fig. 3A, in order to facilitate disconnecting the common electrode E2 in the second non-display region R0, to prevent the signal on the common electrode E2 from being transmitted to the second non-display region R0 to cause electrochemical reaction, and to avoid the occurrence of dark spot defects, the maximum size of the first removed portion GRV1 in the direction perpendicular to the base substrate BS is less than the maximum size of the second removed portion GRV2 in the direction perpendicular to the base substrate BS. The direction perpendicular to the base substrate BS is the third direction Z. The maximum size of the first removed portion GRV1 in the direction perpendicular to the base substrate BS can be the size H1, and the maximum size of the second removed portion GRV2 in the direction perpendicular to the base substrate BS can be the size H2.

For example, as shown in Fig. 3A, the first separation structure 601 is formed into a semi-T-shaped structure, the second separation structure 602 is formed into a semi-T-shaped structure, and the size of the second separation structure 602 in the direction perpendicular to the base substrate BS is greater than the size of the first separation structure 601 in the direction perpendicular to the base substrate BS. Because the maximum depth of the first removed portion GRV1 is less than the maximum depth of the second removed portion GRV2, the size of the second separation structure 602 in the direction perpendicular to the base substrate BS is greater than the size of the first separation structure 601 in the direction perpendicular to the base substrate BS. For example, the size of the second separation structure 602 in the direction perpendicular to the base substrate BS can be the sum of the maximum depth H2 of the second removed portion GRV2 and the thickness of the fourth separation portion PT4. The size of the first separation structure 601 in the direction perpendicular to the base substrate BS can be the sum of the maximum depth H1 of the first removed portion GRV1 and the thickness of the second separation portion PT2. In the embodiment of the present disclosure, the thickness of the fourth separation portion PT4 can be equal to the thickness of the second separation portion PT2. For example, in the embodiment of the present disclosure, as shown in Fig. 3A, the thickness of the inorganic insulating layer Y0 (passivation layer PVX2) is equal everywhere, but it is not limited thereto.

In the embodiment of the present disclosure, a semi-T-shape can be one part of left and right parts into which the T-shape is divided from the middle. For example, the second separation portion PT2 protrudes only at the edge of one side of the first separation portion PT1.

For example, as shown in Fig. 11 and Fig. 16- Fig. 18, the display panel further includes a third separation structure 603 (separation structure 600), the third separation structure 603 is located in the second non-display region R0, and the third separation structure 603 is closer to the first non-display region R3 than the second separation structure 602 is. A plurality of separation structures are arranged in the second non-display region to better disconnect the common electrode E2.

For example, as shown in Fig. 16- Fig. 18, the material of the third separation structure 603 is different from the material of the second separation structure 602. Forming separation structures of different materials can ensure that the common electrode E2 is disconnected in the second non-display region R0.

For example, as shown in Fig. 16- Fig. 18, the material of the third separation structure 603 is a conductive material.

For example, as shown in Fig. 16 and Fig. 18, the distance M3 between the third separation structure 603 and the base substrate BS is different from the distance M2 between the second separation structure 602 and the base substrate BS, so that the common electrode E2 is disconnected at different heights in the third direction Z. For example, as shown in Fig. 16 and Fig. 18, the distance M3 between the third separation structure 603 and the base substrate BS is less than the distance M2 between the second separation structure 602 and the base substrate BS, so that separation structures for disconnecting the common electrode E2 are arranged at different heights in the third direction Z to facilitate disconnecting the common electrode E2. The same benchmark is used to compare the distances. For example, the distance between the separation structure 600 and the base substrate BS can refer to the distance between the bottom end of the separation structure and the base substrate BS. For example, the bottom end of the separation structure can refer to the bottom wall of the groove on which the separation structure is located.

For example, as shown in Fig. 16- Fig. 18, the third separation structure 603 is I-shaped, and the material of the third separation structure 603 includes metal. This setting is beneficial to manufacturing the third separation structure 603. For example, the third separation structure 603 can be formed in the same etching process as the electrode pattern layer is formed.

For example, as shown in Fig. 3A and Fig. 16- Fig. 18, the third separation structure 603 includes a first sub-layer 6031 (fifth separation portion PT5), a second sub-layer 6032 (sixth separation portion PT6) and a third sub-layer 6033 (seventh separation portion PT7). For example, the first sub-layer 6031 (fifth separation portion PT5), the second sub-layer 6032 (sixth separation portion PT6) and the third sub-layer 6033 (seventh separation portion PT7) can be made of metal, respectively. The second sub-layer 6032 (the sixth separation portion PT6) shrinks relative to the first sub-layer 6031 (the fifth separation portion PT5) and the third sub-layer 6033 (the seventh separation portion PT7), thereby forming an I-shaped structure to form the third protruding portion PR3. For example, the third separation structure 603 can be a stacked structure formed of three sub-layers of titanium/aluminum/titanium (Ti/Al/Ti). In the etching process, the etching rate of the intermediate layer is high, thus forming an undercut structure.

For example, as shown in Fig. 16, the display panel further includes a conductive line CDL, the conductive line CDL is located in the second non-display region R0, and the orthographic projection of the inorganic insulating layer Y0 on the base substrate BS overlaps with the orthographic projection of the conductive line CDL on the base substrate BS. The conductive line CDL can be at least one of a gate line and a data line. The conductive line CDL can be a winding line in the second non-display region R0. The conductive line CDL bypasses the first non-display region R3 to connect the sub-pixels located at both sides of the first non-display region R3. The structure and setting position of the conductive line CDL are not limited to those shown in the figure.

As shown in Fig. 18, the second separation structure 602 and the third separation structure 603 are provided, so that the light-emitting functional layer FL (common layer CL) and the common electrode E2 can be disconnected at the corresponding positions of the separation structures when the light-emitting functional layer FL (common layer CL) and the common electrode E2 are formed subsequently.

As shown in Fig. 18, a part of the light-emitting functional layer FL (common layer CL) and a part of the common electrode E2 fall into the second removed portion GRV2, so that the light-emitting functional layer FL (common layer CL) is disconnected at the second protruding portion PR2 of the second separation structure 602.

As shown in Fig. 18, the light-emitting functional layer FL (common layer CL) is disconnected at the second separation structure 602 to form a separated portion FL1, a separated portion FL2 and a separated portion FL3, and the light-emitting functional layer FL (common layer CL) is disconnected at the third separation structure 603 to form a separated portion FL4 and a separated portion FL5.

As shown in Fig. 18, the separated portion FL2 is located in the second removed portion GRV2, and the separated portion FL4 is located on the third separation structure 603. As shown in Fig. 18, the separated portion FL4 is in contact with the third separation structure 603.

As shown in Fig. 18, the common electrode E2 is disconnected at the second separation structure 602 to form a separated portion E21, a separated portion E22 and a separated portion E23, and the common electrode E2 is disconnected at the third separation structure 603 to form a separated portion E24 and a separated portion E25. As shown in Fig. 18, the separated portion E22 is located in the second removed portion GRV2, and the separated portion E24 is located on the third separation structure 603.

Fig. 3B also shows a separated portion of the light-emitting functional layer FL located in the first removed portion GRV1, a separated portion of the light-emitting functional layer FL located in the second removed part GRV2, a separated portion of the common electrode E2 located in the first removed portion GRV1, and a separated portion of the common electrode E2 located in the second removed portion GRV2.

The embodiment of the present disclosure is illustrated by taking that the third separation structure 603 is a conductive structure as an example; however, it is not limited thereto. The third separation structure 603 can also adopt a structure similar to the second separation structure 602. In some embodiments, the third separation structure 603 may not be provided. In some other embodiments, the second separation structure 602 may not be provided.

For example, in some embodiments, the second separation structures 602 can be provided as one or more. Each second separation structure 602 has a ring-shape surrounding the first non-display region R3. Fig. 11 is illustrated by taking that the display panel includes one second separation structure 602 as an example. The number of the second separation structures 602 can be set as needed.

For example, in some embodiments, the third separation structure 603 can be provided as one or more. Each third separation structure 603 has a ring shape surrounding the first non-display region R3. Fig. 11 is illustrated by taking that the display panel includes one third separation structure 603 as an example. Fig. 16- Fig. 18 are illustrated by taking that the display panel includes four third separation structures 603 as an example. The number of the third separation structures 603 can be set as needed.

Fig. 23 is a cross-sectional view of a display panel provided by an embodiment of the present disclosure. Compared with the display panel shown in Fig. 3A or 3B, in the display panel shown in Fig. 23, the position of the second separation portion PT2 (passivation layer PVX2, inorganic insulating layer Y0) of the first separation structure 601 is adjusted. As shown in Fig. 23, the second separation portion PT2 (passivation layer PVX2, inorganic insulating layer Y0) is located between the planarization sub-layer PLN3-1 and the planarization sub-layer PLN3-2.

As shown in Fig. 1, Fig. 3A, Fig. 3B and Fig. 23, an embodiment of the present disclosure provides a display panel, which includes a base substrate BS, a plurality of pixel circuits 100, an insulating layer ISL, a plurality of pixel electrodes E1, a light-emitting functional layer FL, and a first separation structure 601. The plurality of pixel circuits 100 are located on the base substrate BS. The insulating layer ISL is located on one side of the plurality of pixel circuits 100 facing away from the base substrate BS, and includes a plurality of planarization layers, and each planarization layer includes an organic material. The pixel electrode E1 is located on one side of the plurality of planarization layers facing away from the base substrate BS and connected to one pixel circuit 100 among the plurality of pixel circuits 100. The light-emitting functional layer FL includes a common layer CL, the orthographic projection of the common layer CL on the base substrate BS overlaps with the orthographic projection of the plurality of pixel electrodes E1 on the base substrate BS, and at least part of the common layer CL is located on one side of the plurality of pixel electrodes E1 facing away from the base substrate BS. As shown in Fig. 3A, Fig. 3b and Fig. 23, the second separation portion PT2 of the first separation structure 601 has a first protruding portion PR1 protruding from the planarization layer below it. As shown in Fig. 3A, Fig. 3b and Fig. 23, the first separation structure 601 is configured to disconnect the common layer CL (light-emitting functional layer FL) at the first protruding portion PR1. As shown in Fig. 3A, Fig. 3b and Fig. 23, the first separation structure 601 is located between adjacent pixel electrodes E1 and includes an inorganic material, and the first separation structure 601 is located on at least part of the planarization layers.

As shown in Fig. 23, the first separation structure 601 is separated from the plurality of pixel electrodes E1 by at least part of the planarization layers. For example, the first separation structure 601 being separated from the plurality of pixel electrodes E1 by at least part of the planarization layers, means that at least a part of one planarization layer is arranged between the first separation structure 601 and the plurality of pixel electrodes E1.

The display panel shown in Fig. 23 provided by the embodiment of the present disclosure has at least one of the following effects. Firstly, the second separation portion PT2 of the first separation structure 601 has a first protruding portion PR1 protruding from the planarization layer below it, and the pixel electrodes E1 and the first separation structure 601 are separated by at least part of the planarization layers, thus ensuring the flatness, facilitating the planarization of the pixel electrodes E1, improving the light efficiency and enhancing the display effect (at the dashed frame F3 of the display panel shown in Fig. 3A, the pixel electrode E1 is located above the passivation layer PVX2 and in contact with the passivation layer PVX2). Secondly, the pixel electrodes E1 and the first separation structure 601 are separated by at least part of the planarization layers, and the first separation structure 601 is located below the pixel electrodes E1, so even if there is a limit of small spacing between the pixel electrodes, bilateral disconnect (dual-sided disconnect) can be achieved to improve the disconnecting effect. Thirdly, the pixel defining layer PDL is not in direct contact with the structure for forming the first separation structure 601, thus avoiding the risk of peeling of the pixel defining layer PDL (at the dashed frame F2 of the display panel shown in Fig. 3A, the pixel defining layer PDL is in contact with the passivation layer PVX2). Fourthly, the structure for forming the first separation structure 601 can be set smaller, which is beneficial to the outgassing of the planarization layer in an annealing process and reduces the outgas risk caused by the subsequent high-temperature process. Fifthly, the influence on the bending performance of the display panel can be reduced. Sixthly, the lateral crosstalk of adjacent sub-pixels can be avoided. For example, the structure for forming the first separation structure 601 includes a passivation layer PVX2.

Fig. 3A, Fig. 3b and Fig. 23 all adopt bilateral disconnect (dual-sided disconnect), but in other embodiments, a single-sided disconnect (one-sided disconnect) can also be adopted. In the mode of one-sided disconnect, corresponding to the same first removed portion GRV1, there is one first protruding portion PR1, forming one disconnect position. In the mode of dual-sided disconnect, corresponding to the same first removed portion GRV1, there are two first protruding portions PR1, forming two disconnect positions.

For example, as shown in Fig. 23, the second organic insulating layer Y2 is located on one side of the electrode pattern layer LY close to the base substrate BS, and the second organic insulating layer Y2 has a via hole Va, so that the pixel electrode E1 is connected with the pixel circuit 100 through the via hole Va.

As shown in Fig. 23, the planarization sub-layer PLN3-2 (second organic insulating layer Y0) has a through hole HL2 at the first separation structure 601, and the through hole HL2 is communicated with the first removed portion GRV1 and is communicated with the opening PN in the pixel defining layer PDL, so as to facilitate disconnecting the light-emitting functional layer FL by the first separation structure 601. In some embodiments, the first separation structure 601 can further disconnect the common electrode E2.

For example, as shown in Fig. 3A, Fig. 3b and Fig. 23, the display panel further includes a first connection electrode CE1 and a second connection electrode CE2, the pixel circuit 100 includes a transistor T1; the first connection electrode CE1 is located on the planarization layer PLN1 and connected to the transistor T1 through a via hole penetrating the planarization layer PLN1; the second connection electrode CE2 is located on the planarization layer PLN2 and connected to the first connection electrode CE1 through a via hole penetrating the planarization layer PLN2; and the pixel electrode E1 is located on the planarization layer PLN3 and connected to the second connection electrode CE2 through a via hole penetrating the planarization layer PLN3.

For example, as shown in Fig. 3A, Fig. 3b and Fig. 23, the transistor T1 includes a gate electrode GT1, a gate insulating layer GI1, an active layer AT1, a first electrode Ea, and a second electrode Eb; and the first electrode Ea and the second electrode Eb are connected to both ends of the active layer AT1, respectively. The first connection electrode CE1 is connected to the second electrode Eb. For example, the active layer AT1 of the transistor T1 adopts low-temperature poly-silicon (LTPS), but it is not limited thereto.

Fig. 23 further shows a via hole Vb in the planarization layer PLN2 and a via hole Vc in the insulating layer ISL. The pixel electrode E1 is connected to the second connection electrode CE2 through the via hole Va, the second connection electrode CE2 is connected to the first connection electrode CE1 through the via hole Vb, and the first connection electrode CE1 is connected to the second electrode Eb through the via hole Vc.

For example, as shown in Fig. 3A, Fig. 3b and Fig. 23, the pixel circuit 100 further includes a transistor T2, the transistor T2 includes a gate electrode GT2, a gate electrode GT3, a gate insulating layer GI2, a gate insulating layer GI3, an active layer AT2, a first electrode Ec, and a second electrode Ed; and the first electrode Ec and the second electrode Ed are connected to both ends of the active layer AT2, respectively. For example, the gate electrode GT2 and the gate electrode GT3 of the transistor T2 form a dual-gate structure to improve the performance of the transistor T2. For example, the active layer AT2 of the transistor T2 adopts an oxide semiconductor, such as indium gallium zinc oxide (IGZO), but it is not limited thereto.

For example, as shown in Fig. 3A, Fig. 3b and Fig. 23, the insulating layer ISL further includes an inorganic insulating layer PVX1, the inorganic insulating layer PVX1 is located between the pixel circuit 100 (including the transistor T1 and the transistor T2) and the planarization layer PLN1, and the first connection electrode CE1 further penetrates the inorganic insulating layer PVX1.

For example, as shown in Fig. 3A, Fig. 3b and Fig. 23, the inorganic insulating layer PVX1 is disposed on one side of the planarization layer close to the base substrate BS.

For example, as shown in Fig. 3A, Fig. 3b and Fig. 23, the pixel electrode E1 is connected to one pixel circuit 100 of the plurality of pixel circuits 100 through a via hole penetrating at least part of the insulating layer ISL. In the case where a connection electrode is provided, the pixel electrode E1 is connected to the connection electrode through a via hole penetrating at least part of the insulating layer ISL, and the connection electrode is connected to the pixel circuit 100. In the case where a connection electrode is not provided, the pixel electrode E1 is connected to the pixel circuit 100 through a via hole penetrating the insulating layer ISL.

For example, as shown in Fig. 3A, Fig. 3b and Fig. 23, the base substrate BS includes a first base substrate PI1, a barrier layer BR1, and a second base substrate PI2. Of course, the structure of the base substrate BS is not limited to that described above. For example, the base substrate BS can also adopt a single-layer structure.

For example, the base substrate BS can be a flexible base substrate, but it is not limited thereto. The flexible base substrate is bendable to reduce the bezel or form a foldable display panel.

As shown in Fig. 3A, Fig. 3b and Fig. 23, the barrier layer BR2 is located on the base substrate BS, and a light shielding layer LS is provided on the barrier layer BR2, a buffer layer BF1 is provided on the light shielding layer LS, a buffer layer BF2 is provided on the buffer layer BF1, an active layer AT2 is provided on the buffer layer BF2 , a gate insulating layer GI1 is provided on the active layer AT2, a gate electrode GT1 is located on the gate insulating layer GI1, and a buffer layer BF3 is provided on the gate electrode GT1, a gate electrode GT2 is provided on the buffer layer BF3, a gate insulating layer GI2 is provided on the gate electrode GT2, an active layer AT2 is provided on the gate insulating layer GI2, a gate insulating layer GI3 is provided on the active layer AT2, an interlayer insulating layer ILD is provided on the gate insulating layer GI3, and a first electrode Ea, a second electrode Eb, a first electrode Ec, and a second electrode Ed are provided on the interlayer insulating layer ILD. The light shielding layer LS can block light to improve the performance of the transistor T1.

For example, the barrier layer BR2 and the barrier layer BR1 can adopt the same material, but not limited thereto.

As shown in Fig. 3A, Fig. 3b and Fig. 23, the display panel further includes a connection electrode Ee, and the connection electrode Ee can be connected with the light shielding layer LS. The connection electrode Ee can be connected to any other signal line, such as a power line providing a constant voltage, so as to reduce the resistance of the power line. For example, the power line can be a signal line providing a power voltage VDD. The connection electrode Ee is located on the interlayer insulating layer ILD, and can be arranged in the same layer as the first electrode Ea, the second electrode Eb, the first electrode Ec, and the second electrode Ed.

As shown in Fig. 3A, Fig. 3b and Fig. 23, the display panel further includes a connection electrode CEa and a connection electrode CEb, the connection electrode CEa is connected with the connection electrode CEb, the connection electrode CEa is located on the planarization layer PLN1, the connection electrode CEb is located on the planarization layer PLN2, and the connection electrode CEb is connected with the connection electrode CEa through a via hole penetrating the planarization layer PLN2. The connection electrode CEa and the connection electrode CE1 are located in the same layer, and the connection electrode CEb and the connection electrode CE2 are located in the same layer.

As shown in Fig. 3A, Fig. 3b and Fig. 23, the display panel further includes a storage capacitor Cst, and the storage capacitor Cst includes a first electrode plate Ca and a second electrode plate Cb. For example, the first electrode plate Ca and the gate electrode GT1 are located in the same layer, and the second electrode plate Cb and the gate electrode GT2 are located in the same layer.

As shown in Fig. 3A, Fig. 3b and Fig. 23, the display panel further includes spacers PS, and the spacers PS are configured to support a fine metal mask during the evaporation deposition process of the local layer LL in the light-emitting functional layer FL.

For example, the spacers PS can be integrated with the pixel defining layer PDL, and can be manufactured by using a two-tone mask.

For example, as shown in Fig. 3A, Fig. 3b and Fig. 23, in order to facilitate the planarization of the pixel electrode E1, the planarization layer PLN3 includes a planarization sub-layer PLN3-1 and a planarization sub-layer PLN3-2. The planarization sub-layer PLN3-1 is closer to the base substrate BS than the planarization sub-layer PLN3-2 is. Of course, in other embodiments, the planarization layer PLN3 can also adopt a single-layer structure.

As shown in Fig. 23, a passivation layer PVX2 is disposed on the planarization sub-layer PLN3-1 (part of the planarization layer PLN3), and the passivation layer PVX2 and the pixel electrodes E1 are separated by the planarization sub-layer PLN3-2 (part of the planarization layer PLN3). In Fig. 23, a first removed portion GRV1 is formed in the planarization sub-layer PLN3-1.

In some other embodiments, the position of the passivation layer PVX2 can also be adjusted to be located between the planarization layer PLN2 and the planarization layer PLN3, the passivation layer PVX2 is disposed on the planarization layer PLN2 (part of the planarization layers), and the passivation layer PVX2 and the pixel electrodes E1 are separated by the planarization layer PLN3 (part of the planarization layers). In this case, the first removed portion GRV1 is formed in the planarization layer PLN2.

In some other embodiments, the position of the passivation layer PVX2 can also be adjusted to be located between the planarization layer PLN1 and the planarization layer PLN2, the passivation layer PVX2 is disposed on the planarization layer PLN1 (part of the planarization layers), and the passivation layer PVX2 and the pixel electrodes E1 are separated by the planarization layer PLN2 and the planarization layer PLN3 (part of the planarization layers). In this case, the first removed portion GRV1 is formed in the planarization layer PLN1.

Compared with the display panels shown in Fig. 3A and Fig. 3B, the first separation structure 601 and the second separation structure 602 can be moved down to form a display panel with different structures. That is, the passivation layer PVX2 moves down, and in this case, in the display region, the planarization layer on the passivation layer PVX2 has a through hole, the through hole is communicated with the opening N0 in the pixel defining layer PDL and is communicated with the first removed portion GRV1, so that the first separation structure 601 can play a role in disconnecting the light-emitting functional layer. It should be noted that the first separation structure 601 and the second separation structure 602 can be disposed above the planarization layer PLN1 and can be disposed at any film layer position separated from the pixel electrode E1 by at least part of the planarization layer.

In the embodiment of the present disclosure, the passivation layer PVX2 is an inorganic insulating layer Y0, the planarization layer located below the passivation layer PVX2 and in contact with the passivation layer PVX2 is a first organic insulating layer Y1, and the planarization layer located above the passivation layer PVX2 and in contact with the passivation layer PVX2 is a second organic insulating layer Y2.

For example, as shown in Fig. 23, the passivation layer PVX2 is located between two adjacent sub-pixels. For example, the passivation layer PVX2 is located in the middle of two adjacent sub-pixels, and the width of the passivation layer PVX2 can be designed to be about 5 µm, forming dual-sided disconnect to enhance the disconnect effect.

In the embodiment of the present disclosure, the first organic insulating layer Y1 can be one or more film layers. For example, the first organic insulating layer Y1 includes at least one planarization layer. In the display panel shown in Fig. 3A and Fig. 3B, the first organic insulating layer Y1 is a planarization sub-layer PLN3-2. In the display panel shown in Fig. 23, the first organic insulating layer Y1 can be a planarization sub-layer PLN3-1 or a stacked structure of the planarization sub-layer PLN3-1, the planarization layer PLN2, and the planarization layer PLN1.

In the embodiment of the present disclosure, the first separation structure 601 is formed of an organic insulating layer (planarization layer) and an inorganic insulating layer (passivation layer PVX2) located thereon. The second separation structure 602 is formed of an organic insulating layer (planarization layer) and an inorganic insulating layer (passivation layer PVX2) located thereon. The number of planarization layers contained in the organic insulating layers of the first separation structure 601 and the second separation structure 602 may be the same or different.

As shown in Fig. 3A, Fig. 3b and Fig. 23, the plurality of pixel circuits 100 and the plurality of light-emitting elements 200 are provided. As shown in Fig. 3A, Fig. 3b and Fig. 23, the pixel circuit 100 includes a transistor T1 and a transistor T2.

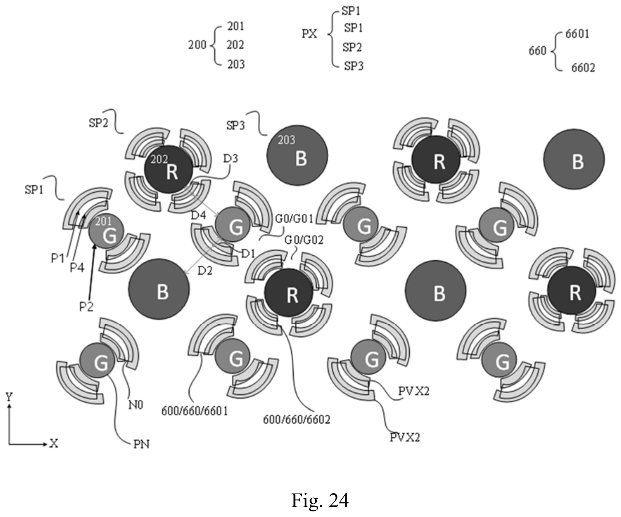

Fig. 24 is a plan view of a display panel provided by an embodiment of the present disclosure.

For example, as shown in Fig. 24, the first separation structure 601 surrounding one light-emitting element 200 includes a plurality of separation sub-structures 660. As shown in Fig. 24, the first separation structure 601 surrounding the light-emitting element 201 includes two separation sub-structures 660. As shown in Fig. 24, the first separation structure 601 surrounding the light-emitting element 202 includes four separation sub-structures 660.

For example, as shown in Fig. 24, the plurality of separation sub-structures 660 at least include two separation sub-structures 660 located at opposite sides of the light-emitting region (position P2 is the outer edge of the light-emitting region, corresponding to the opening PN) of the light-emitting element 200. This arrangement facilitates the formation of a gap G0 between adjacent separation sub-structures 660. Providing the gap G0 is beneficial to the continuity of the common electrode E2 and the application of signals on the common electrode E2. That is, it facilitates that the common electrodes E2 corresponding to adjacent light-emitting elements are formed into an integrated structure, which is beneficial to the application of signals. That is, the common electrode E2 can be disconnected at the first separation structure 601 and connected at the gap G0, thus ensuring the continuity of the common electrodes E2 of different light-emitting elements. Of course, a full circle of separation structure can also be provided, that is, the separation structure surrounds the light-emitting region for a full circle. In this case, the common electrodes E2 corresponding to different sub-pixels can be connected through other film layers.

For example, as shown in Fig. 24, at least one separation sub-structure 660 among the plurality of separation sub-structures 660 has unequal distances to two light-emitting elements 200 adjacent thereto. As shown in Fig. 24, for the light-emitting element 201 and the light-emitting element 203 adjacent thereto, the distance D1 is less than the distance D2. As shown in Fig. 24, for the light-emitting element 201 and the light-emitting element 202 adjacent thereto, the distance D3 is less than the distance D4. The first separation structure 601 (separation sub-structure 660) between adjacent light-emitting elements is disposed close to one of the adjacent light-emitting elements. In the case where two first protruding portions PR1 are arranged in one opening N0, the center line between the two first protruding portions PR1 can be used as one end for distance calculation.

As shown in Fig. 24, position P1 is a position where one first protruding portion PR1 of the first separation structure 601 is located, position P4 is a position where another first protruding portion of the first separation structure 601 is located, and position P2 is the outer edge of the light-emitting region of the light-emitting element of the sub-pixel, and corresponds to the edge of the opening N0. The plan view shown in Fig. 24 corresponds to a case in which one first separation structure 601 has two first protruding portions PR1 and dual-sided disconnect is achieved.

For example, as shown in Fig. 24, the light-emitting region of the first light-emitting element 201 is smaller than the light-emitting region of the second light-emitting element 202, the light-emitting region of the second light-emitting element 202 is smaller than the light-emitting region of the third light-emitting element 203, the first separation structure 601 includes a first separation structure 601 and a second separation structure 602, the first separation structure 601 is located at the periphery of the light-emitting region of the first light-emitting element 201, and the second separation structure 602 is located at the periphery of the light-emitting region of the second light-emitting element 202.

For example, as shown in Fig. 24, the first separation structure 601 includes two first separation sub-structures 6601 located at opposite sides of the light-emitting region of the first light-emitting element 201, the second separation structure 602 includes four second separation sub-structures 6602, the four second separation sub-structures 6602 are arranged around the light-emitting region of the second light-emitting element 202, two second separation sub-structures 6602 of the four second separation sub-structures 6602 are located at opposite sides of the light-emitting region of the second light-emitting element 202, and the other two second separation sub-structures 6602 of the four second separation sub-structures 6602 are located at opposite sides of the light-emitting region of the second light-emitting element 202. As shown in Fig. 24, the four second separation sub-structures 6602 are sequentially arranged around the light-emitting region of the second light-emitting element 202. As shown in Fig. 24, a gap G01 is provided between two first separation sub-structures 6601. As shown in Fig. 24, a gap G02 is provided between two adjacent second separation sub-structures 6602. The size of the gap G01 is greater than the size of the gap G02.

For example, as shown in Fig. 24, the light-emitting region of the first light-emitting element 201 is surrounded by two first separation sub-structures 6601 and two second separation sub-structures 6602 located at the gaps of the first separation sub-structures 6601. Therefore, the first separation structure 601/separation sub-structure 660 is provided in the regions between the first light-emitting element 201 and two second light-emitting elements 202 adjacent thereto, and in the regions between the first light-emitting element 201 and two third light-emitting elements 203 adjacent thereto, which is beneficial to reducing or avoiding crosstalk between adjacent sub-pixels.

For example, as shown in Fig. 24, the light-emitting region of the third light-emitting element 203 is surrounded by four first separation sub-structures 6601 and two second separation sub-structures 6602. Therefore, the first separation structure 601/separation sub-structure 660 is provided in the regions between the third light-emitting element 203 and two second light-emitting elements 202 adjacent thereto, and in the regions between the third light-emitting element 203 and four first light-emitting elements 201 adjacent thereto, which is beneficial to reducing or avoiding crosstalk between adjacent sub-pixels.

For example, as shown in Fig. 24, the first light-emitting element 201 is configured to emit green light, the second light-emitting element 202 is configured to emit red light, and the third light-emitting element 203 is configured to emit blue light. Fig. 24 is illustrated by taking as an example that the first light-emitting element 201 is configured to emit green light, the second light-emitting element 202 is configured to emit red light, and the third light-emitting element 203 is configured to emit blue light. However, the luminous color of the light-emitting elements provided by the embodiment of the present disclosure is not limited to this case, and can be determined as needed.

For example, as shown in Fig. 24, the repeating unit PX includes two first sub-pixels SP1, one second sub-pixel SP2, and one third sub-pixel SP3. For example, as shown in Fig. 24, in one repeating unit PX, the second sub-pixel SP2 and the third sub-pixel SP3 are respectively arranged at both sides of the center connecting line of the two first sub-pixels SP1. Of course, the pixel arrangement of the display panel is not limited to that shown in Fig. 24, and the pixel arrangement can be set as needed.

As shown in Fig. 24, the distance between a separation sub-structure 660 arranged around the light-emitting region of one light-emitting element and the light-emitting region of the light-emitting element is greater than the distance between the separation sub-structure 660 and the light-emitting region of a light-emitting element adjacent to the light-emitting element. That is, if a separation sub-structure 660 is arranged around the light-emitting region of a certain light-emitting element, the separation sub-structure 660 is closer to the light-emitting region of the certain light-emitting element.

Fig. 24 takes as an example that a plurality of passivation layers PVX2 are arranged around the light-emitting region of the light-emitting element to form the first separation structure 601; however, it is not limited to this case. The passivation layer PVX2 arranged around the light-emitting region of the light-emitting element can also be arranged in a full-circle structure, as long as a plurality of discrete openings N0 are arranged around the light-emitting region of the same light-emitting element. For a plurality of separation sub-structures arranged around the light-emitting region of the same light-emitting element, the position between adjacent openings N0 is the gap G0. That is, in the embodiment of the present disclosure, in order to facilitate the continuity of the common electrode E2, a plurality of openings N0 are provided around the light-emitting region of the same light-emitting element, and the region between adjacent openings N0 is the gap G0.

Fig. 24 takes that the first separation structure 601/separation sub-structure 660 is arc-shaped as an example, but it is not limited to this case, and can be set as needed. For example, the first separation structure 601/separation sub-structure 660 can be set according to the shape of the outer edge of the light-emitting region of the light-emitting element.

In the embodiment of the present disclosure, the planar shape of the first removed portion GRV1 can be as shown in Fig. 24, and the planar shape of the first removed portion GRV1 can be an arc shape, but it is not limited thereto. The planar shape of the first removed portion GRV1 can refer to the shape of the first separation structure 601 or the separation sub-structure 660 shown in Fig. 24. Of course, the planar shape of the first removed portion GRV1 can also be a ring shape. For example, for a region between sub-pixels of the display region, a plurality of first removed portions GRV1 can be distributed in a discrete manner, or connected in a contiguous or meshed manner.

In the embodiment of the present disclosure, the planar shape of the second removed portion GRV2 can be a ring shape. For example, in the second non-display region R0, the second removed portion GRV2 can be a region of one circle or a region of more circles or a ring-shaped region.

In the embodiment of the present disclosure, the first protruding portion PR1, the second protruding portion PR2, and the third protruding portion PR3 all protrude in the lateral direction, which can also be called lateral protruding portions respectively. In the separation structure, an upper separation portion protrudes from a lower separation portion at the edge, which can also be regarded as that the lower separation portion shrinks to form a protruding portion. The protruding portion may refer to at least one of the first protruding portion PR1, the second protruding portion PR2, and the third protruding portion PR3.

It should be noted that in the embodiment of the present disclosure, the pixel circuit 100 includes a transistor T1, a transistor T2 and a storage capacitor. For example, the transistor T1 can be a light-emitting control transistor, and the transistor T2 can be a threshold compensation transistor or a reset control transistor, but it is not limited thereto. The structure of the pixel circuit 100 is not limited in the embodiment of the present disclosure, and conventional pixel circuits can be adopted. For example, the pixel circuit 100 can adopt a pixel circuit of 7T1C, a pixel circuit of 7T2C, a pixel circuit of 8T1C or a pixel circuit of 9T1C. Of course, the number of transistors and the number of capacitors included in the pixel circuit 100 are not limited to those described above, and can be determined as needed. The connection relationship between transistors or between the transistor and the capacitor is not shown in the cross-sectional view, and conventional structures can be provided here.

For example, in the embodiment of the present disclosure, components located in the same layer can be formed by the same film layer through the same patterning process. In the embodiment of the present disclosure, patterning or a patterning process may include only a photolithography process, or may include a photolithography process and an etching step, or may include other processes for forming a predetermined pattern, such as printing, inkjet, etc. The photolithography process refers to a process including processing procedures, such as film formation, exposure and development, etc., and forming patterns by using photoresist, a mask and an exposure machine, etc. A corresponding patterning process can be selected according to the structure formed in the embodiment of the present disclosure.

For example, in the embodiment of the present disclosure, in the case where the planarization layer PLN3 includes a planarization sub-layer PLN3-1 and a planarization sub-layer PLN3-2, the thickness of the planarization sub-layer PLN3-1 can be in the range of 1-2 µm, and the thickness of the planarization sub-layer PLN3-2 can be in the range of 1-2 µm. For example, in this case, the thickness of the planarization layer PLN3 can be in the range of 2-4 µm.

For example, in the embodiment of the present disclosure, in the case where the planarization layer PLN3 has a single-layer structure, the thickness of the planarization layer PLN3 can be in the range of 1-2 µm.

For example, in the embodiment of the present disclosure, the thickness of the planarization layer PLN1 can be in the range of 1-2 µm.

For example, in the embodiment of the present disclosure, the thickness of the planarization layer PLN2 can be in the range of 1-2 µm.

For example, in the embodiment of the present disclosure, the thickness of the passivation layer PVX1 can be in the range of 0.1-0.25 µm.

For example, in the embodiment of the present disclosure, the base substrate BS, the barrier layer BR, the barrier layer BR1, the barrier layer BR2, the buffer layer BF1, the buffer layer BF2, the buffer layer BF3, the gate insulating layer GI1, the gate insulating layer GI2, the gate insulating layer GI3, the interlayer insulating layer ILD, the passivation layer PVX1, the passivation layer PVX2, the planarization layer PLN1, the planarization layer PLN2, the planarization layer PLN3, and the pixel defining layer PDL are all made of insulating materials.

For example, the material of the base substrate BS includes polyimide, but it is not limited thereto. For example, the material of the base substrate PI1 includes polyimide, but it is not limited thereto. For example, the material of the base substrate PI2 includes polyimide, but it is not limited thereto. For example, the base substrate BS can be a flexible base substrate, so as to form a flexible display panel.

For example, the material of at least one of the barrier layer BR, the barrier layer BR1, the barrier layer BR2, the buffer layer BF1, the buffer layer BF2, the buffer layer BF3, the gate insulating layer GI1, the gate insulating layer GI2, the gate insulating layer GI3, the interlayer insulating layer ILD, the passivation layer PVX1 and the passivation layer PVX2 includes an inorganic insulating material. For example, the inorganic insulating material includes at least one of silicon oxide, silicon nitride or silicon oxynitride.

For example, the materials of the pixel defining layer PDL and the planarization layer include organic insulating materials. For example, the planarization layer PLN1, the planarization layer PLN2, and the planarization layer PLN3 include organic insulating materials. For example, the organic insulating material includes one or a combination of acrylic, polyethylene terephthalate, polyimide, polyamide, polycarbonate, epoxy resin, etc.

For example, in the embodiment of the present disclosure, both the pixel defining layer PDL and the planarization layer can be called organic layers or organic insulating layers. For example, each of the planarization layer PLN1, the planarization layer PLN2, and the planarization layer PLN3 can be called an organic layer. The pixel defining layer PDL can be called an organic layer. The planarization sub-layer PLN3-1 can be called an organic sub-layer or an organic insulating sub-layer, and the planarization sub-layer PLN3-2 can be called an organic sub-layer or an organic insulating sub-layer.

For example, in the embodiment of the present disclosure, the insulating layer ISL can also be called an insulating material layer.

The structure of the display panel provided by the embodiment of the present disclosure is not limited to that shown in the figure, and the structure of the display panel can be adjusted as needed; for example, some film layers can be removed or some film layers can be added, and some components can be removed or some components can be added. For example, Fig. 3A, Fig. 3b and Fig. 23 take as an example that the pixel electrode E1 is connected to the second electrode Eb through two connection components (the first connection electrode CE1 and the second connection electrode CE2). In some other embodiments, other numbers of connection components, such as one or more than two connection components may be provided.

For example, in the embodiment of the present disclosure, at least one of the gate electrode GT1, the gate electrode GT2, the gate electrode GT3, the first electrode plate Ca, the second electrode plate Cb, the first electrode Ea, the second electrode Eb, the first electrode Ec, the second electrode Ed, the first connection electrode CE1, the second connection electrode CE2, the connection electrode CEa, the connection electrode CEb and the connection electrode CEc is made of a metal or an alloy.

For example, in the embodiment of the present disclosure, the active layer AT1 and the active layer AT2 are semiconductor layers and can be made of poly-silicon or a metal oxide semiconductor material.

For example, in the embodiment of the present disclosure, one of the pixel electrode E1 and the common electrode E2 is the anode of the light-emitting element, and the other of the pixel electrode E1 and the common electrode E2 is the cathode of the light-emitting element. The embodiment of the present disclosure is illustrated by taking that the pixel electrode E1 is an anode and the common electrode E2 is a cathode as an example.

For example, the pixel electrode E1 is made of a conductive material. For example, the material of the pixel electrode E1 includes metal and conductive metal oxide. For example, the pixel electrode E1 has a structure in which indium tin oxide (ITO), silver (Ag) and indium tin oxide (ITO) are stacked. The material and structure of the pixel electrode E1 can be set as needed.

For example, the common electrode E2 is made of a conductive material. For example, the material of the common electrode E2 includes a metal or an alloy. For example, the material of the common electrode E2 includes Mg/Ag alloy. The material and structure of the common electrode E2 can be set as needed.

It should be noted that the embodiment of the present disclosure is illustrated by taking that the common layer CL includes a first common layer CL1, a second common layer CL2, and a third common layer CL3 as an example, but it is not limited to this case. The common layer CL may have a single-layer structure or a stacked structure including a plurality of film layers. For example, in some embodiments, the common layer CL at least includes a charge generation layer.

For example, in the embodiment of the present disclosure, at least one film layer in the light-emitting functional layer FL can be manufactured by evaporation deposition process.

It should be noted that the embodiment of the present disclosure is illustrated by taking that the light-emitting element has a tandem structure as an example, but it is not limited to this case, and other suitable structures may be adopted for the light-emitting element.

For example, the display panel can further include an encapsulation layer, and the encapsulation layer is configured to encapsulate a plurality of light-emitting elements to avoid water and oxygen invasion.

For example, the pixel defining layer PDL can adopt a black pixel defining layer. Generally, the structure of color filter on encapsulation (COE) can be paired with the black pixel defining layer.

For example, the display panel can further include a touch layer, and the touch layer can be disposed between the encapsulation layer and the COE structure.

For example, in the embodiment of the present disclosure, the conductive line CL, the conductive line CDL and the third separation structure 603 can be located in the same layer, for example, in the same layer as the source and drain electrodes of the transistor.

In some accompanying drawings of the embodiments of the present disclosure, a plan view shows a first direction X and a second direction Y, and a cross-sectional view shows a third direction Z. Both the first direction X and the second direction Y are directions parallel with the main surface of the base substrate BS. The third direction Z is a direction perpendicular to the main surface of the base substrate BS. For example, the first direction X is intersected with the second direction Y. The embodiment of the present disclosure is illustrated by taking that the first direction X is perpendicular to the second direction Y as an example. For example, the main surface of the base substrate BS is the surface of the base substrate BS for manufacturing various elements thereon. The upper surface of the base substrate BS in the cross-sectional view is the main surface of the base substrate BS. The third direction Z is perpendicular to the first direction X and is perpendicular to the second direction Y.

An embodiment of the present disclosure further provides a display device, which includes any of the above display panels.

For example, the display device can be a display, such as an organic light-emitting diode display device, etc., or any product or component having display function and including the display, such as a TV, a digital camera, a mobile phone, a watch, a tablet computer, a laptop computer, a navigator, etc. The embodiment of the present disclosure includes but is not limited to this case.

The above are only specific embodiments of the present disclosure, but the protection scope of the present disclosure is not limited thereto. Any person skilled in the art can easily think of changes or substitutions within the technical scope disclosed in the present disclosure, it should be covered within the protection scope of the present disclosure. Therefore, the protection scope of the present disclosure should be determined by the protection scope of the claims.

## Claims

1. A display panel, comprising:
a base substrate, comprising a display region and a peripheral region located on at least one side of the display region;
a first organic insulating layer, located in the display region and the peripheral region;
a plurality of sub-pixels, comprising a plurality of light-emitting elements, wherein the plurality of light-emitting elements are located in the display region and located on one side of the first organic insulating layer facing away from the base substrate, the plurality of light-emitting elements comprise an electrode pattern layer, a common electrode, and a light-emitting functional layer located between the electrode pattern layer and the common electrode, the electrode pattern layer comprises a plurality of pixel electrodes independent from each other, the light-emitting functional layer comprises a plurality of film layers, and the electrode pattern layer is closer to the base substrate than the common electrode is;
an inorganic insulating layer, located in the display region and the peripheral region, and located on one side of the first organic insulating layer facing away from the base substrate;
a second organic insulating layer, located on one side of the inorganic insulating layer facing away from the base substrate; and
a first separation structure, located between adjacent sub-pixels of the plurality of sub-pixels, the first separation structure being configured to disconnect at least one film layer of the plurality of film layers of the light-emitting functional layer,
wherein the first separation structure comprises a first separation portion and a second separation portion, the first separation portion is located in the first organic insulating layer, and the second separation portion is located in the inorganic insulating layer,
the inorganic insulating layer has a plurality of through holes located in the peripheral region, and the second organic insulating layer is in contact with the first organic insulating layer through the plurality of through holes.

2. The display panel according to claim 1, wherein the plurality of through holes are covered by the second organic insulating layer.

3. The display panel according to claim 1 or 2, wherein the plurality of through holes are formed in a plurality of rows and a plurality of columns.

4. The display panel according to any one of claims 1-3, wherein the plurality of through holes comprise at least two through holes which are staggered in a first direction and a second direction, and the first direction and the second direction are perpendicular to each other and are parallel with the base substrate.

5. The display panel according to any one of claims 1-4, wherein the second separation portion protrudes from the first separation portion at an edge to form a first protruding portion, and at least one film layer of the plurality of film layers of the light-emitting functional layer is disconnected at the first protruding portion.

6. The display panel according to any one of claims 1-5, wherein the base substrate further comprises a first non-display region, the first non-display region is a non-light-emitting region, a second non-display region is arranged between the first non-display region and the display region, the display panel further comprises a second separation structure located in the second non-display region, the second separation structure is configured to disconnect at least one film layer of the plurality of film layers and to disconnect the common electrode, the second separation structure comprises a third separation portion and a fourth separation portion, the third separation portion is located in the first organic insulating layer, and the fourth separation portion is located in the inorganic insulating layer.

7. The display panel according to claim 6, wherein the first organic insulating layer has a first removed portion at the first separation structure, and the first organic insulating layer has a second removed portion at the second separation structure.

8. The display panel according to claim 7, wherein a maximum depth of the first removed portion is less than a maximum depth of the second removed portion.

9. The display panel according to claim 7, wherein a maximum size of the first removed portion in a direction perpendicular to the base substrate is less than a maximum size of the second removed portion in the direction perpendicular to the base substrate.

10. The display panel according to any one of claims 6-9, wherein the fourth separation portion protrudes from the third separation portion at an edge to form a second protruding portion, and at least one film layer of the plurality of film layers of the light-emitting functional layer and the common electrode are disconnected at the second protruding portion.

11. The display panel according to any one of claims 6-10, wherein the first separation structure is formed into a semi-T-shaped structure, the second separation structure is formed into a semi-T-shaped structure, and a size of the second separation structure in a direction perpendicular to the base substrate is greater than a size of the first separation structure in the direction perpendicular to the base substrate.

12. The display panel according to any one of claims 6-11, further comprising a third separation structure, wherein the third separation structure is located in the second non-display region, and the third separation structure is closer to the first non-display region than the second separation structure is.

13. The display panel according to claim 12, wherein a material of the third separation structure is different from a material of the second separation structure.

14. The display panel according to claim 12 or 13, wherein a material of the third separation structure is a conductive material.

15. The display panel according to any one of claims 12-14, wherein a distance between the third separation structure and the base substrate is less than a distance between the second separation structure and the base substrate.

16. The display panel according to any one of claims 12-15, wherein the third separation structure is I-shaped, and a material of the third separation structure comprises metal.

17. The display panel according to any one of claims 6-16, further comprising a conductive line, wherein the conductive line is located in the second non-display region, and an orthographic projection of the inorganic insulating layer on the base substrate overlaps with an orthographic projection of the conductive line on the base substrate.

18. The display panel according to any one of claims 1-17, wherein the second organic insulating layer is located on one side of the electrode pattern layer facing away from the base substrate, and the second organic insulating layer comprises a plurality of openings configured to expose the plurality of pixel electrodes.

19. The display panel according to any one of claims 1-17, wherein the second organic insulating layer is located on one side of the electrode pattern layer close to the base substrate, and the second organic insulating layer has a via hole so that the pixel electrode is connected with a pixel circuit through the via hole.

20. A display device, comprising the display panel according to any one of claims 1-19.
